# EUROPEAN PATENT APPLICATION

(11) **EP 2 439 776 A2**
(43) Date of publication of application: **11.04.2012**
(21) Application number: 11008116.3
(22) Date of filing: 06.10.2011
(51) Int. Cl.: H01L 23/66, H01L 23/48, H01L 23/367, H01Q 1/38, H01Q 1/22

(54) **Antenna on an integrated circuit**

(30) Priority: 07.10.2010 US 390810 P; 07.02.2011 US 22291
(71) Applicant: Broadcom Corporation, Irvine, CA 92617 (US)
(72) Inventor: Zhao, Sam Ziqun, Irvine, CA 92618 (US); Behzad, Arya, Poway, CA 92064 (US); Boers, Michael, Irvine, CA 92618 (US); Rofougaran, Ahmadreza, Newport Coast, CA 92657 (US); Castaneda, Jesus, Los Angeles, CA 90066 (US)
(74) Representative: Jehle, Volker Armin

(57) **Abstract**

An integrated circuit (IC) device arrangement includes a substrate (202), an IC die (204) coupled to the substrate, an antenna (206) coupled to the IC die, and a first wirelessly enabled functional block (210) coupled to the IC die. The wirelessly enabled functional block is configured to wirelessly communicate with a second wirelessly enabled functional block (212) coupled to the substrate. The antenna is configured to communicate with another antenna coupled to another device.

## Description

### CROSS REFERENCE TO RELATED APPLICATIONS

This application claims the benefit of U.S. Provisional Appl. No. 61/390,810, filed October 7, 2010, which is incorporated by reference herein in its entirety.

### BACKGROUND

### Field

The present invention generally relates to integrated circuit (IC) devices, and more particularly to communications involving IC devices.

### Background

Integrated circuit (IC) devices typically include an IC die housed in a package. The IC device can be coupled to a printed circuit board (PCB) to enable communication between the IC device and other devices coupled to the PCB. For example, in array-type packages, an IC die is often coupled to a substrate, which is coupled to an array of connection elements, e.g., an array of solder balls. The array of connections elements is then physically coupled to the PCB.

An IC die can be coupled to a substrate in a variety of ways. For example, in die-down flip-chip packages, solder bumps can be used to couple contact pads on a surface of the IC die to contact pads located on the substrate. In another example, wirebonds can be used to couple bond pads on a surface of the IC die to bond fingers located on the substrate.

Conventional ways of coupling an IC die to a substrate can, however, be costly. For example, the materials used to create wirebonds, e.g., gold, can be expensive, thus increasing the cost of the entire device. Furthermore, the conventional ways of coupling the IC die to the substrate can also be susceptible to manufacturing defects. For example, wirebonds and/or solder bumps can break or be damaged during the manufacturing process, reducing the throughput for the IC device.

Furthermore, conventional ways of coupling different IC devices can also have drawbacks. For example, when IC devices are coupled together using a PCB, the elements used to couple the IC devices to the PCB can break or be damaged during manufacturing or field application.

What is needed, then, is an IC device that provides for cost-effective and reliable interconnections between an IC die and a substrate and between different IC dies.

### BRIEF SUMMARY

In embodiments described herein, integrated circuit (IC) devices and methods of assembling IC devices are provided. In one embodiment, an IC device includes a substrate, an IC die coupled to the substrate, an antenna coupled to the IC die, and a first wirelessly enabled functional block coupled to the IC die. The wirelessly enabled functional block is configured to wirelessly communicate with a second wirelessly enabled functional block coupled to the substrate. The antenna is configured to communicate with another antenna coupled to another device.

In another embodiment, a method of manufacturing an IC device includes providing an IC die, forming an antenna on the IC die, forming a first wirelessly enabled functional block on the IC die, and coupling the IC die to a substrate. The antenna is configured to communicate with another antenna coupled to another device. The first wirelessly enabled functional block is configured to wirelessly communicate with a second wirelessly enabled functional block coupled to the substrate.

In another embodiment, an IC device includes an IC die and an antenna coupled to the IC die. The antenna is configured to communicate with another antenna coupled to another device.

According to an aspect of the invention, an integrated circuit (IC) device comprises:
a substrate;
an IC die coupled to the substrate;
an antenna coupled to the IC die, wherein the antenna is configured to communicate with another antenna coupled to another device; and
a first wirelessly enabled functional block coupled to the IC die, wherein the wirelessly enabled functional block is configured to wirelessly communicate with a second wirelessly enabled functional block coupled to the substrate.
Advantageously, the antenna comprises at least one of a dipole antenna and a patch antenna.
Advantageously, the IC device further comprises an antenna plane that includes the antenna.
Advantageously, the antenna plane comprises at least one of a capacitor, inductor, coil, and a balun.
Advantageously, the antenna plane comprises a metal tape attached to the IC die.
Advantageously, the antenna plane comprises an etcheable metal layer coupled to a substrate.
Advantageously, the antenna spreads heat from the IC die to the substrate.
Advantageously, the antenna is coupled to the substrate.
Advantageously, the antenna comprises at least one of a slot antenna and a patch antenna.
Advantageously, the IC device further comprises a heat spreader coupled to the IC die and the substrate.
Advantageously, the heat spreader comprises a waveguide.
Advantageously, the first wirelessly enabled circuit block is coupled to the antenna through a via.
Advantageously, the IC device further comprises a second substrate having an insulating layer and an etcheable metal layer, wherein the etcheable metal layer includes the antenna.
Advantageously, the first wirelessly enabled circuit block comprises a transceiver.
According to a further aspect, a method is provided of manufacturing an integrated circuit (IC) device, comprising:
providing an IC die;
forming an antenna on the IC die, wherein the antenna is configured to communicate with another antenna coupled to another device;
forming a first wirelessly enabled functional block on the IC die; and
coupling the IC die to a substrate, wherein the first wirelessly enabled functional block is configured to wirelessly communicate with a second wirelessly enabled functional block coupled to the substrate.
Advantageously, forming the antenna comprises forming a dipole antenna or forming a patch antenna.
Advantageously, forming the antenna comprises forming an antenna plane that includes the antenna.
Advantageously, the method further comprises coupling the antenna to the substrate.
Advantageously, the method further comprises coupling a heat spreader to the IC die.
According to an aspect, an integrated circuit (IC) device is provided, comprising:
an IC die; and
an antenna coupled to the IC die, wherein the antenna is configured to communicate with another antenna coupled to another device.

These and other advantages and features will become readily apparent in view of the following detailed description of the invention. Note that the Summary and Abstract sections may describe one or more, but not all exemplary embodiments of the present invention as contemplated by the inventor(s).

### BRIEF DESCRIPTION OF THE DRAWINGS/FIGURES

The accompanying drawings, which are incorporated herein and form a part of the specification, illustrate the present invention and, together with the description, further serve to explain the principles of the invention and to enable a person skilled in the pertinent art to make and use the invention.

FIG. 1 is a cross sectional view of a conventional die down ball grid array (BGA) package.

FIGS. 2 and 3 are cross-sectional views of die down IC devices, according to embodiments of the invention.

FIG. 4 is a diagram of a wirelessly enabled functional block, according to an embodiment of the invention.

FIGS. 5 and 6 show top views of antenna planes, according to embodiments of the invention.

FIG. 7 shows a cross sectional view of an IC package, according to an embodiment of the invention.

FIG. 8 shows a top view of an antenna, according to an embodiment of the invention.

FIG. 9 shows a cross sectional view of an IC package, according to an embodiment of the invention.

FIG. 10 shows a top view of an antenna, according to an embodiment of the invention.

FIG. 11 shows a cross sectional view of an IC package, according to an embodiment of the invention.

FIG. 12 shows a top view of a waveguide structure, according to an embodiment of the invention.

FIG. 13 is a flowchart of example steps for assembling IC devices, according to embodiments of the invention.

The present invention will now be described with reference to the accompanying drawings. In the drawings, like reference numbers indicate identical or functionally similar elements. Additionally, the left-most digit(s) of a reference number identifies the drawing in which the reference number first appears.

### DETAILED DESCRIPTION OF THE INVENTION

References in the specification to "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

Furthermore, it should be understood that spatial descriptions (e.g., "above", "below", "left," "right," "up", "down", "top", "bottom", etc.) used herein are for purposes of illustration only, and that practical implementations of the structures described herein can be spatially arranged in any orientation or manner.

### Conventional Packages

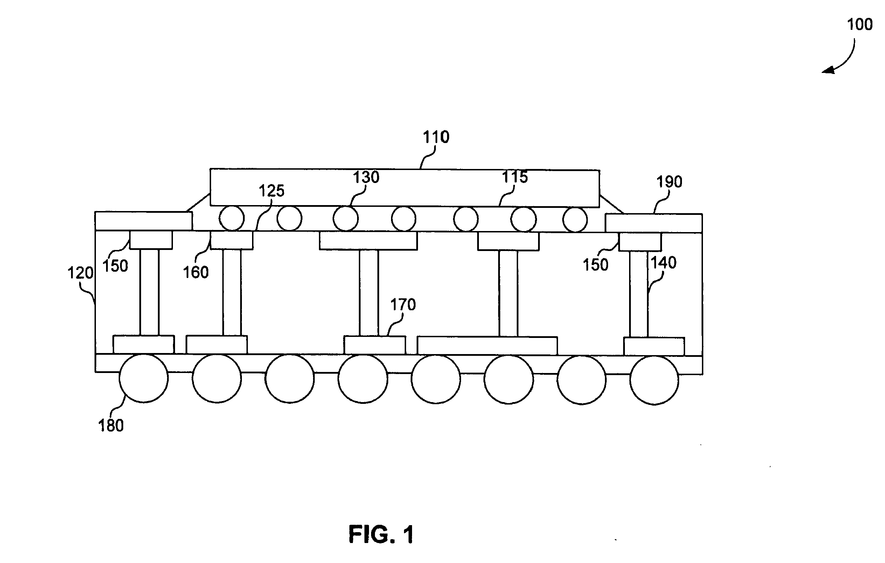

FIG. 1 shows a cross sectional view of a conventional die down ball grid array (BGA) package 100. BGA package 100 includes a die 110 coupled to a top surface 125 of a substrate 120 via solder bumps 130. BGA package 100 is a die down package in which an active surface 115 of die 110 faces substrate 120. On the other hand, in die up packages, the active surface of the die faces away from the substrate.

Active surface 115 often includes power and ground distribution rails and input/output contact pads. A plurality of solder bumps 130 can be distributed across active surface 115 of flip chip die 110 to respectively connect flip chip die 110 to substrate 120. As shown in FIG. 1, a solder mask 190 surrounds the area where solder bumps 130 are located.

In the embodiment of FIG. 1, vias 140 connect solder bumps 130, traces, and/or via pads 150 at top surface 125 of substrate 120 to solder balls 180 at a bottom surface of substrate 120. As shown in FIG. 1, substrate 120 can include bump pads 160 and ball pads 170. Bump pads 160 are connected to solder bumps 130 at top surface 125 of substrate 120. Ball pads 170 are connected to solder balls 180 at the bottom surface of substrate 120. Solder balls 180 can electrically connect flip chip BGA package 100 to any suitable surface having electrically conductive connections, such as a PCB.

### Exemplary Embodiments

In embodiments described herein, IC packages are provided that include an antenna coupled to an IC die. The antenna can be used to communicate with other IC devices. The antenna can also be coupled to first wirelessly enabled functional blocks on the IC die. The first wirelessly enabled functional blocks can be configured to communicate with second wirelessly enabled functional blocks on a substrate. Advantages of these packages include a streamlined manufacturing process, increased flexibility in forming interconnections, improved throughput, and decreased manufacturing yield loss.

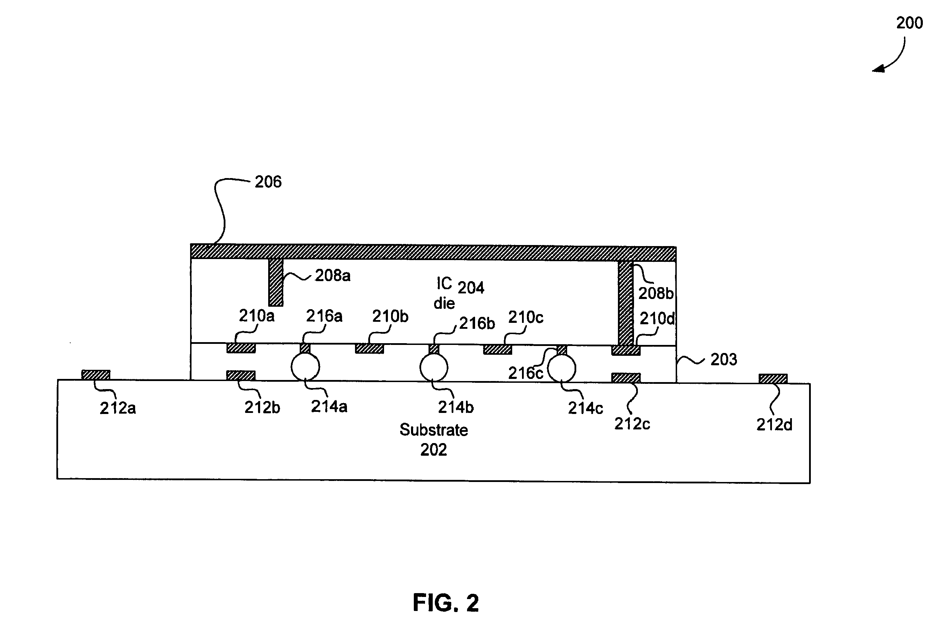

FIG. 2 shows a cross sectional view of an IC package 200, according to an embodiment of the present invention. IC package 200 includes a substrate 202, an adhesive 203, an IC die 204, an antenna plane 206, vias 208a and 208b (collectively, "208"), first wirelessly enabled functional blocks 210a-d (collectively "210"), second wirelessly enabled functional blocks 212a-d (collectively "212"), solder bumps 214a-c (collectively "214"), and contact pads 216a-c (collectively "216").

Adhesive 203 attaches IC die 204 to substrate 202. In an embodiment, adhesive 203 is an electrically non-conductive epoxy.

In an embodiment, substrate 202 is similar to substrate 120 described with reference to FIG. 1. Substrate 202 can be used to facilitate coupling IC package 200 to a printed circuit board (PCB). For example, substrate 202 can include contact pads on the bottom surface of substrate 202 that can be used to couple IC package 200 to the PCB thorough an array of elements, e.g., an array of solder balls, pins, or the like. In alternate embodiments, substrate 202 can have another set of wirelessly enabled functional blocks that are configured to wirelessly communicate with a set of wirelessly enabled functional blocks of the PCB. The operation of wirelessly enabled functional blocks will be described below.

Antenna plane 206 is coupled to the top surface of IC die 204. As will be described further below, antenna plane 206 can include various components including an antenna used to communicate with other devices. In an embodiment, antenna plane 206 can be formed from an etcheable metal layer on the top surface of IC die 204. In another embodiment, antenna plane 206 can be a metal tape coupled to the top surface of IC die 204. Alternatively, antenna plane 206 can also be a rigid printed wire board (PWB) coupled to the top surface of IC die. In another embodiment, antenna plane 206 can include multiple metal layers, e.g., two or four metal layers.

First wirelessly enabled functional blocks 210 are coupled to the bottom surface of IC die 204 and second wirelessly enabled functional blocks 212 are coupled to the top surface of substrate 202. In an embodiment, each one of first wirelessly enabled functional blocks 210 is configured to communicate with one of second wirelessly enabled functional blocks 212. For example, frequency division, timing division, and/or code division methods can be used so that each one of second wirelessly enabled functional block 212 only accepts communications from its respective counterpart of first wirelessly enabled functional blocks 210, and vice versa. The structure of first and second wirelessly enabled functional blocks 210 and 212 will be described in greater detail below.

IC die 204 is also coupled to substrate 202 through contact pads 216 and solder bumps 214. In an embodiment, first and second wirelessly enabled functional blocks 210 and 212 can be used to replace pairs of contact pads 216 and solder bumps 214 to improve the performance of the package 200. However, some signals may be communicated using contact pads 216 and solder bumps 214. For example, contact pads 216 and solder bumps 214 can be used to send ground and/or power voltages to IC die 204.

Vias 208 are coupled to antenna plane 206. Vias 208 can be through silicon vias that are formed through a silicon die, e.g., die 204. As shown in FIG. 2, via 208b couples wirelessly enabled functional block 210d to antenna plane 206. In an embodiment, via 208b couples first wirelessly enabled functional block 210d to an antenna plane 206. Additionally or alternatively, via 208b can couple first wirelessly enabled functional block 210d to other components included in antenna plane 206. Via 208a couples antenna plane 206 to a circuit block in IC die 204. The circuit block to which via 208a is coupled can control the operation of an antenna included in antenna plane 206. For example, via 208a can couple the antenna to an amplifier included in IC die 204 used to generate a signal to be transmitted by the antenna and/or to amplify a signal received by the antenna, e.g., a power amplifier or a low noise amplifier.

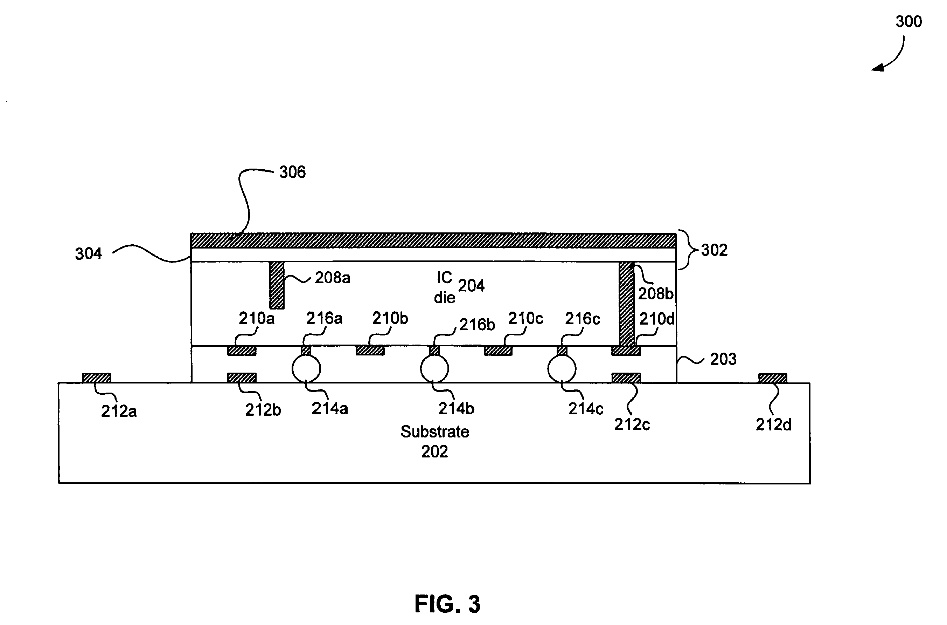

FIG. 3 shows a cross sectional view of an IC package 300, according to an embodiment of the present invention. IC package 300 is substantially similar to IC package 200 except that antenna plane 206 is replaced with a second substrate 302. Second substrate 302 includes an insulator 304 and an etcheable metal layer 306. Insulator 304 can be one of a variety of insulating or dielectric materials known to those skilled in the art, such as FR-4. Etcheable metal layer 306 can be etched to form components such as those included in antenna plane 206. For example, etcheable metal layer 306 can be etched to form an antenna and/or passive devices. In an embodiment, by having the antenna formed on top of an insulated material such as insulating layer 304 instead of on top of an IC die such as IC die 204 (as shown in FIG. 2), the radiating efficiency of antenna is enhanced. In another embodiment, second substrate 302 can include multiple metal layers. For example, second substrate 302 can include two or four metal layers (including etcheable metal layer 306).

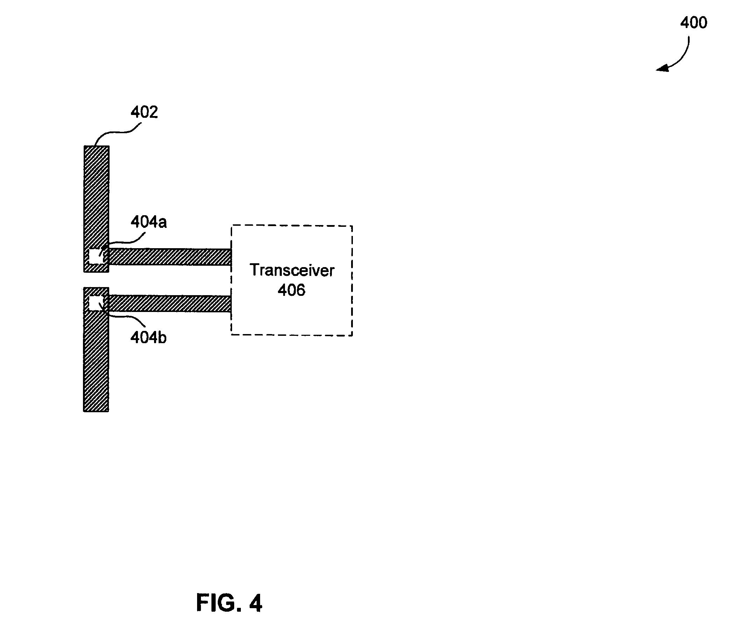

FIG. 4 shows diagram of a wirelessly enabled functional block 400, according to an embodiment of the present invention. Wirelessly enabled functional block 400 includes an antenna 402 and vias 404a and 404b (collectively "404"), which feed antenna 402. In an embodiment, at least one of vias 404 is a through silicon via. One or more of first and second wirelessly enabled functional blocks 210 and 212 can be implemented in a manner substantially similar to wirelessly enabled functional block 400.

As shown in FIG. 4, antenna 402 is a dipole antenna. Other antenna configurations can be used as appropriate. In an embodiment, antenna 402 can be formed out of metal traces or planes. For example, dipole antenna 402 can be formed using traces on the bottom surface of IC die 204 or on the top surface of substrate 202. Antenna 402 can be configured to operate in a certain frequency range (e.g., by adjusting the dimensions of antenna 302). In other embodiments, antenna 402 can be another type of antenna. For example, antenna 402 can be a patch antenna having a square or rectangular shape.

Vias 404 can be used to drive antenna with or received from antenna a single ended signal or a differential signal. For example, via 404a can be coupled to a signal plane and via 404b can be coupled to a circuit block or other element that provides a single-ended signal. Alternatively, each of vias 404 can be coupled to circuit blocks or other elements that provide components of a differential signal.

As shown in FIG. 4, wirelessly enabled functional block 400 optionally includes a transceiver 406. In such an embodiment, antenna 402 is fed by transceiver 406. Transceiver 406 can be coupled to a signal plane using vias of a die or substrate. In an embodiment, transceiver 406 is also coupled to a circuit block or a portion of a PCB (e.g., through a substrate). Transceiver 406 can be configured to transmit signals received from the circuit block or the PCB and/or convey received signals to the circuit block or the PCB. In a further embodiment, transceiver 406 can have additional functionality. For example, transceiver 306 may be capable of performing signal processing tasks such as modulation and demodulation.

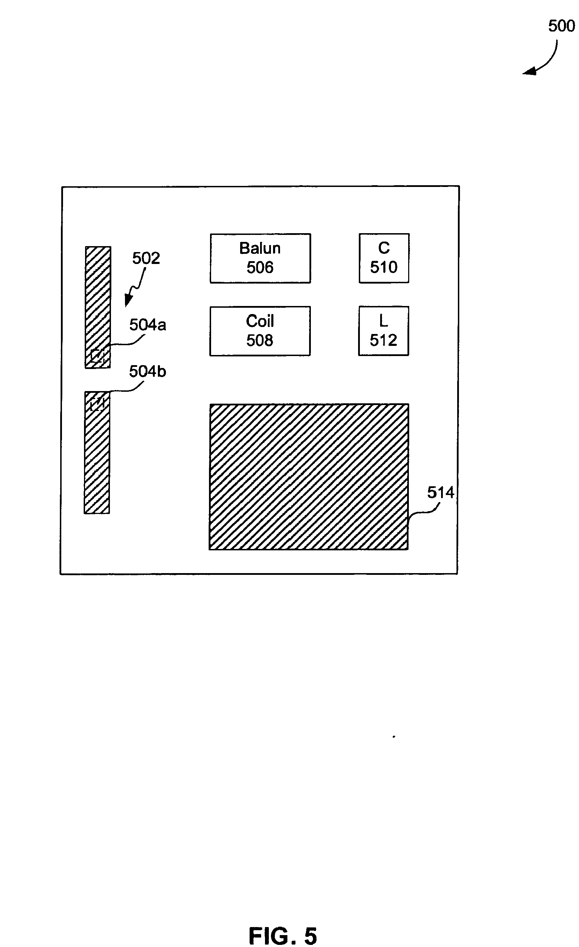

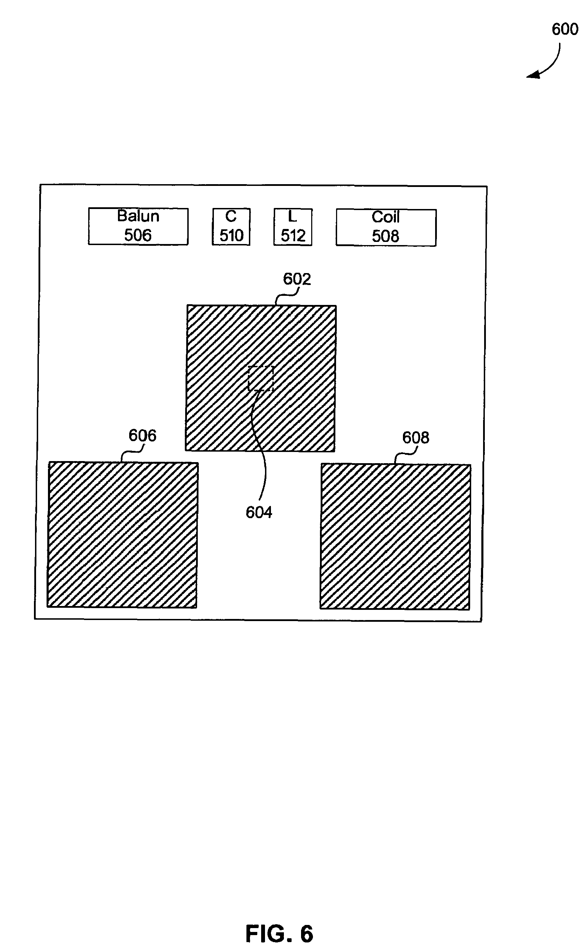

FIGS. 5 and 6 show top views of antenna planes 500 and 600, respectively, according to embodiments of the present invention. Antenna plane 500 includes a dipole antenna 502, a balun 506, a coil 508, a capacitor 510, an inductor 512, and a signal plane 514. In an embodiment one or more of the elements of antenna plane 500 can be formed out of signal traces formed on the top surface of an IC die or an insulating layer.

Dipole antenna 502 includes a pair of metal strips each of which is fed by a respective via of vias 504a and 504b. In an embodiment, vias 504a and 504b can be substantially similar to vias 208 described with reference to FIG. 2. As shown in FIG. 5, dipole antenna 502 is located close to the edge of antenna plane 500. Locating dipole antenna 502 close to the edge can result in increased radiating efficiency because less of the radiation will be absorbed by the IC die and/or insulating layer.

One or more of balun 506, capacitor 510, and inductor 512 can be formed as metal traces on a top side of a inducting layer or IC die surface. Antenna plane 500 also includes a signal plane 514. Signal plane 514 can be configured to be coupled to a power, ground, or other signal. In other embodiments, additional passive components can be implemented in antenna plane 500. Vias similar to vias 208 described with reference to FIG. 2 can be used to couple circuit blocks in an IC die or wirelessly enabled functional blocks to one or more of balun 506, coil 508, capacitor 510, inductor 512 and signal plane 514.

FIG. 6 shows the top view of antenna plane 600, which is similar to signal plane 500. Signal plane 600 includes a patch antenna 602, signal planes 606 and 608, balun 506, capacitor 510, inductor 512, and coil 508. Patch antenna 602 can be fed using a via 604. Via 604 can be coupled to a circuit block of an IC die or can be coupled to a wirelessly enabled functional block. Signal planes 606 and 608 can be coupled to the same or different potentials. For example, signal plane 606 can be coupled to a power plane and signal plane 608 can be coupled to a ground plane. As shown in FIGS. 5 and 6, signal planes 514, 606, and 608 are square or rectangular-shaped. In other embodiments, signal planes 514, 606, and 608 can be other shapes (e.g., trapezoidal, L-shaped, etc.).

In an embodiment, antenna planes 206, shown in FIG. 2, can have some or all of the features of antenna plane 500, antenna plane 600, or a combination thereof. Furthermore, although FIGS. 5 and 6 have been described with reference to the embodiment in which they are top views of antenna planes. In another embodiment, at least one of FIG. 5 or FIG. 6 can be top views of an etcheable metal layer. For example, etcheable metal layer 306, shown in FIG. 3, can have features of the antenna plane 500, antenna plane 600, or a combination thereof.

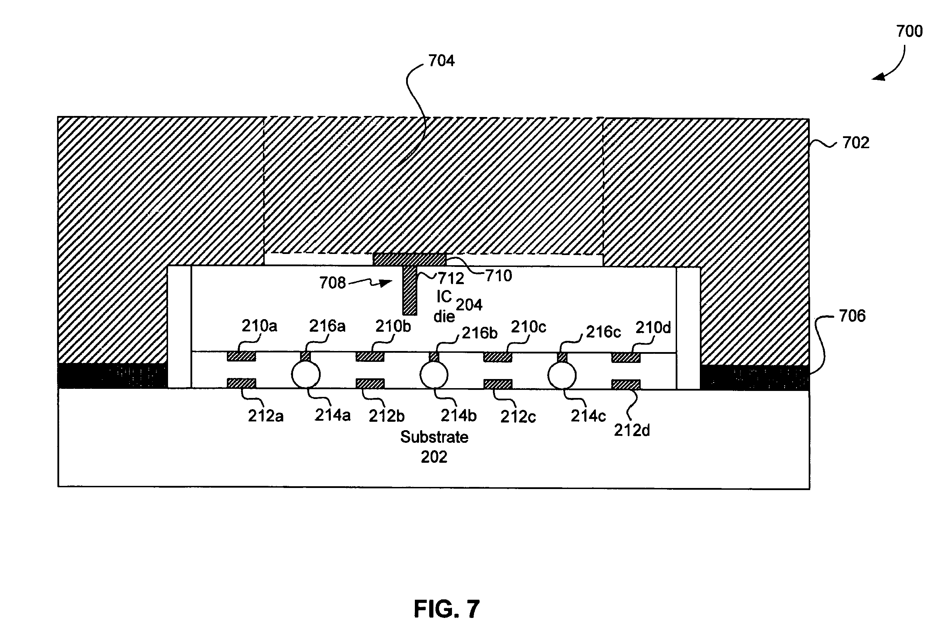

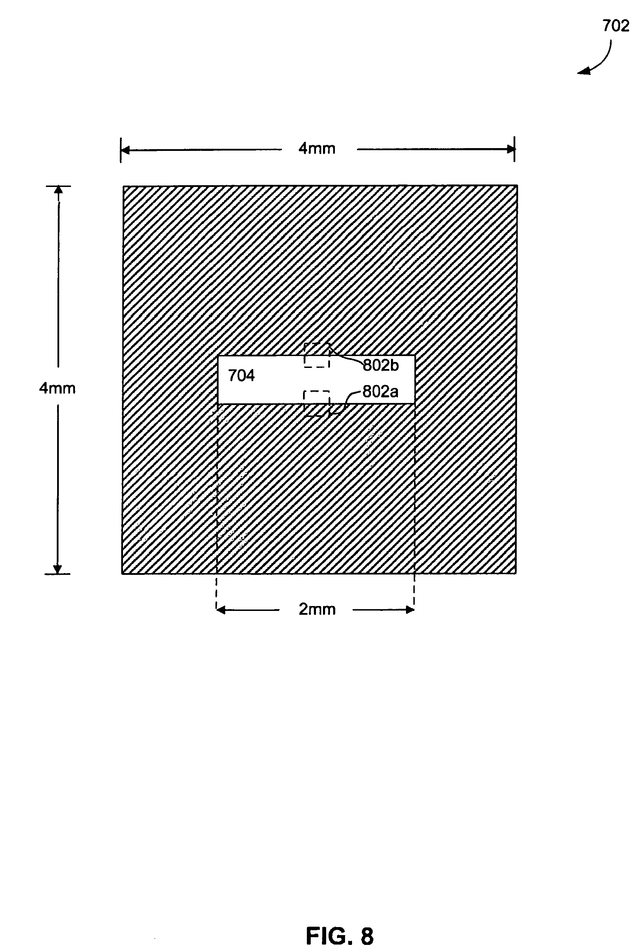

FIG. 7 shows a cross sectional view of an IC package 700, according to an embodiment of the invention. IC package 700 includes many of the same components as IC package 200. For example, IC package 700 includes substrate 202, IC die 204, first wirelessly enabled functional blocks 210, second wirelessly enabled functional blocks 212, solder bumps 214, and contact pads 216. IC package 700 additionally includes an antenna 702 and a feed 708. FIG. 8 shows a top view of antenna 702, according to an embodiment of the invention.

Antenna 702 includes a radiating slot 704. FIG. 8 shows exemplary dimensions for the features of antenna 702. In the embodiment of FIG. 8, radiating slot 704 can be approximately 2mm long. In an embodiment, such a radiating slot 704 can be an effective radiator for electromagnetic radiation at frequencies of approximately 60GHz. In alternate embodiments, radiating slot 704 can have different dimensions and still be used as a radiator for electromagnetic radiation at frequencies of approximately 60GHz. For example, slot 704 can be 3mm long and still be used for electromagnetic radiation at frequencies of approximately 60GHz. Generally, as the dimensions of radiating slot 704 deviate from resonant dimensions, radiating slot 704 will perform worse.

Radiating slot 704 is fed by feed 708. As shown in FIG. 7, feed 708 includes a via 712 and a contact 710. Via 712 can be coupled to a circuit block of IC die 204, e.g., a low noise amplifier or a power amplifier. Dotted boxes 802a and 802b in FIG. 8 show exemplary locations for feeds similar to feed 708. Thus, radiating slot 704 can be fed using feeds located at opposite ends of slot 704. In an embodiment, a pair of feeds 708 can be used to deliver a differential signal to radiating slot 704 or receive a differential signal received at slot 704.

In an embodiment, antenna 702 can also function as a heat spreader. For example, antenna 702 can serve to spread heat from IC die 204 to substrate 202. As shown in FIG. 7, antenna 702 is coupled to substrate 202 through adhesive 706. In an embodiment, adhesive 706 is thermally conductive so that antenna 702 can conduct heat from IC die 204 to substrate 202.

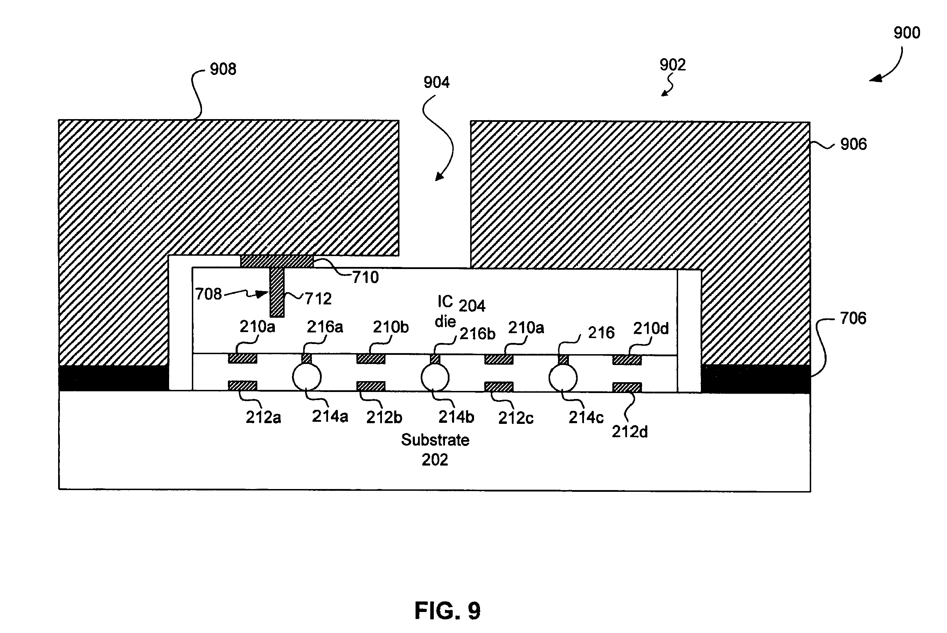

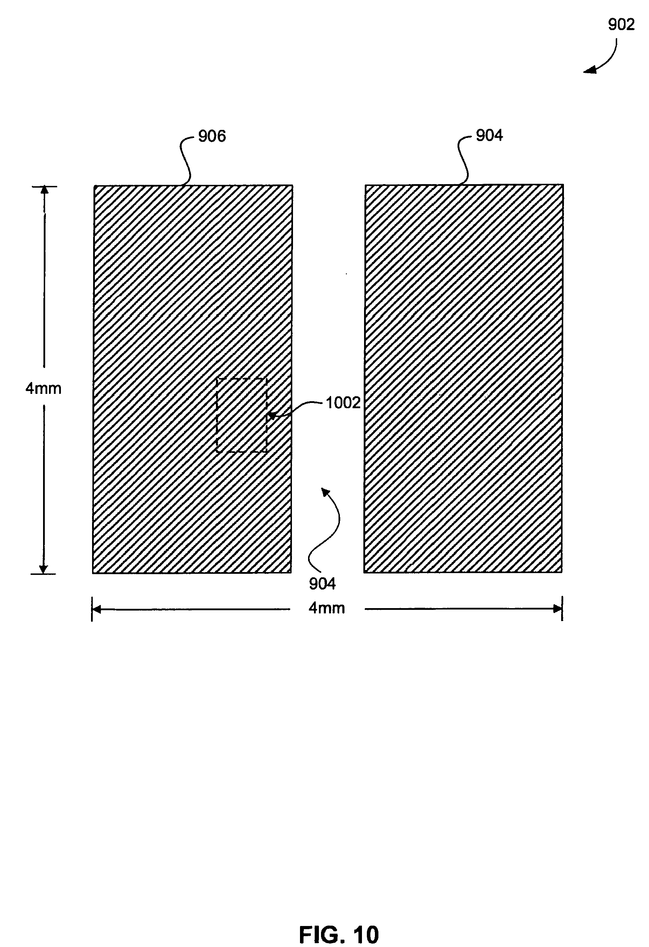

FIG. 9 shows a cross sectional view of an IC package 900, according to an embodiment of the invention. IC package 900 is substantially similar to IC package 700 except that antenna 702 is replaced with antenna 902. FIG. 10 shows a top view of antenna 902 with exemplary dimensions.

Unlike antenna 702, which included a slot through a portion of it, in antenna 902 a slot 904 extends completely through antenna 902. Thus, slot 904 divides antenna 902 into a first portion 906 and a second portion 908. In an embodiment, second portion 908 is coupled to feed 708. Thus, second portion 908 can be a slot antenna that is driven to radiate relative to first portion 906.

As shown in FIG. 10, antenna 902 can be approximately 4mm x 4mm. In such an embodiment, second portion 908 can be an effective radiator for electromagnetic radiation in a frequency range of approximately 10-20GHz. Dotted box 1002 in FIG. 10 is indicative of an exemplary location for feed 708.

As shown in FIG. 10, antenna 902 can also include an optional coupling element 1004. In an embodiment, optional coupling element 1004 electrically couples first portion 906 to second portion 908.

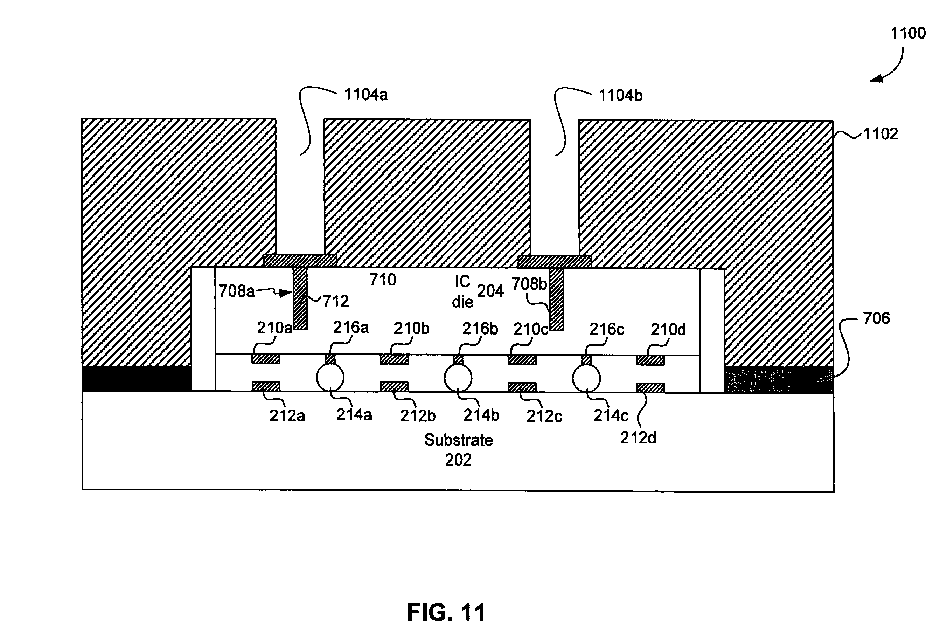

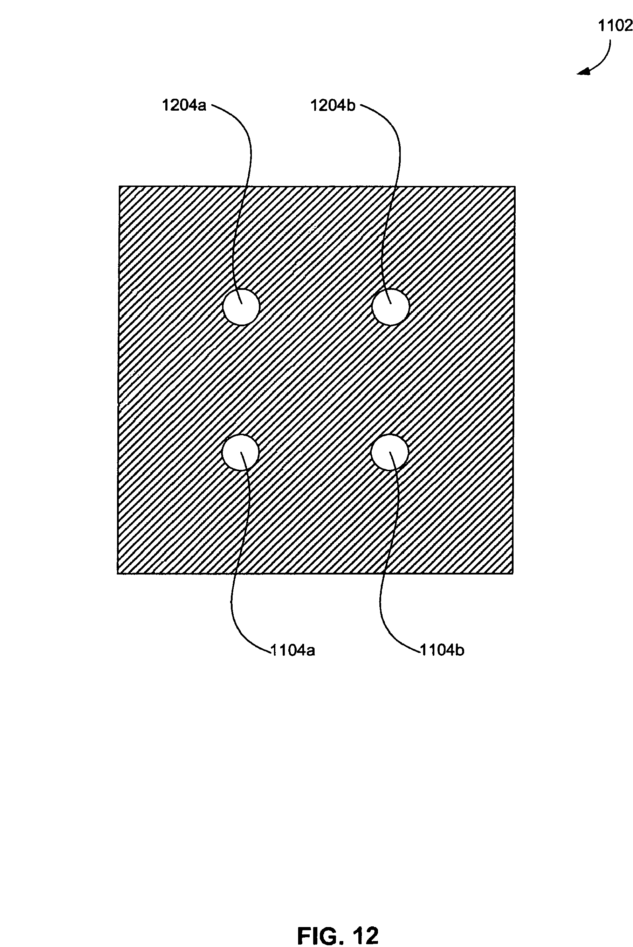

FIG. 11 shows a cross sectional view of an IC package 1100, according to an embodiment of the invention. IC package 1100 is substantially similar to IC package 700, except that 702 is replaced with waveguide structure 1102. FIG. 12 shows a top view of wave guide structure 1102.

As shown in FIG. 11, IC package 1100 includes a pair of feeds 708a and 708b. Unlike IC packages 700 and 900, where feeds 708 were used to feed another radiating structure, feeds 708a and 708b in the embodiment of IC package 1100 are themselves radiators. Waveguides 1104a and 1104b serve to guide the radiation generated by radiators 708a and 708b, respectively.

Waveguide 1104a can optionally be filled with dielectric materials 1106a and 1108a. Similarly, waveguide 1104b can optionally filled with dielectric materials 1106b and 1108b. Dielectric materials 1106a, 1106b, 1108a, and 1108b can be used to enhance the guiding properties of waveguides 1104a and 1104b. For example, dielectric materials 1106a and 1106b can be relatively high dielectric materials (e.g., compared to dielectric materials 1108a and 1108b, respectively). In such an embodiment, waveguides 1104a and 1104b can act as fiber waveguides for radiation generated by feeds 708a and 708b, respectively.

As shown in FIG. 12, waveguide structure 1102 can have additional waveguides 1204a and 1204b. Waveguides 1104a, 1104b, 1204a, and 1204b can be circular in shape. For example, waveguides 1104a, 1104b, 1204a, and 12 04b can have a 1mm diameter. In such an embodiment, waveguides 1104a, 1104b, 1204a, and 1204b can be effective waveguides for electromagnetic radiation having a frequency of approximately 200 GHz.

Waveguides 1204a and 1204b can be filled with dielectric materials 1206a and 1208a and dielectric materials 1206b and 1208b, respectively. In an embodiment, dielectric materials 1206a, 1206b, 1208a, and 1208b can be substantially similar to dielectric materials 1106a, 1106b, 1108a, and 1108b, respectively.

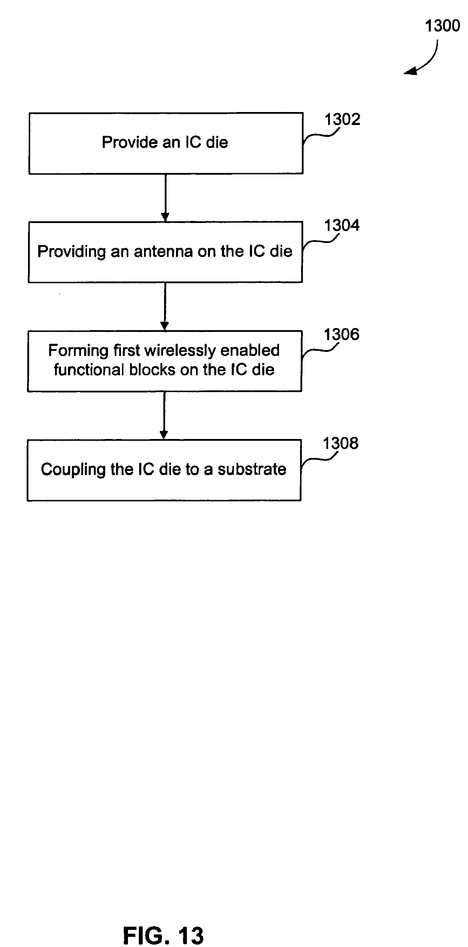

FIG. 13 shows a flowchart 1300 providing example steps for assembling an IC device, according to an embodiment of the invention. Other structural and operational embodiments will be apparent to persons skilled in the relevant art(s) based on the following discussion. The steps shown in FIG. 13 do not necessarily have to occur in the order shown. The steps of FIG. 1300 are described in detail below.

In step 1302, an IC die is provided. For example, in FIG. 2 IC die 204 is provided.

In step 1304, an antenna is provided on the IC die. For example, in FIGS. 2 and 3, antenna planes 206 and etcheable metal layer 306, respectively, provided on IC die 204. In another example, in FIGS. 7 and 9, antennas 702 and 902 are provided that also function as heat spreaders. In still another example, in FIG. 11, feeds 708a and 708b are used as radiators generating radiation that is guided using wave guide structure 1102. In the embodiments of FIGS. 7, 9, and 11 the antenna or waveguide is coupled to the substrate.

In an embodiment, the antenna can be formed before the assembly process and then coupled to the IC die (and, in embodiments, the substrate) during the assembly process. For example, the antenna or waveguide structures in FIGS. 7, 9, and 11 can be formed before the assembly process and coupled to the IC die and substrate during the assembly.

In step 1306, first wirelessly enabled functional blocks are formed on the IC die. For example, in FIG. 2 first wirelessly enabled functional blocks 210 can be formed on IC die 204.

In step 1308, the IC die is coupled to a substrate. For example, in FIG. 2 IC die 204 is coupled to substrate 202 through an adhesive 203.

### Conclusion

While various embodiments of the invention have been described above, it should be understood that they have been presented by way of example only, and not limitation. It will be apparent to persons skilled in the relevant art that various changes in form and detail can be made therein without departing from the spirit and scope of the invention. Thus, the breadth and scope of the present invention should not be limited by any of the above-described exemplary embodiments, but should be defined only in accordance with the following claims and their equivalents.

## Claims

1. An integrated circuit (IC) device, comprising:
a substrate;
an IC die coupled to the substrate;
an antenna coupled to the IC die, wherein the antenna is configured to communicate with another antenna coupled to another device; and
a first wirelessly enabled functional block coupled to the IC die, wherein the wirelessly enabled functional block is configured to wirelessly communicate with a second wirelessly enabled functional block coupled to the substrate.

2. The IC device of claim 1, wherein the antenna comprises at least one of a dipole antenna and a patch antenna.

3. The IC device of claim 1, further comprising an antenna plane that includes the antenna.

4. The IC device of claim 3, wherein the antenna plane comprises at least one of a capacitor, inductor, coil, and a balun.

5. The IC device of claim 3, wherein the antenna plane comprises a metal tape attached to the IC die.

6. The IC device of claim 3, wherein the antenna plane comprises an etcheable metal layer coupled to a substrate.

7. The IC device of claim 1, wherein the antenna spreads heat from the IC die to the substrate.

8. The IC device of claim 1, wherein the antenna is coupled to the substrate.

9. The IC device of claim 8, wherein the antenna comprises at least one of a slot antenna and a patch antenna.

10. The IC device of claim 1, further comprising a heat spreader coupled to the IC die and the substrate.

11. The IC device of claim 10, wherein the heat spreader comprises a waveguide.

12. The IC device of claim 1, wherein the first wirelessly enabled circuit block is coupled to the antenna through a via.

13. The IC device of claim 1, further comprising: a second substrate having an insulating layer and an etcheable metal layer, wherein the etcheable metal layer includes the antenna.

14. A method of manufacturing an integrated circuit (IC) device, comprising:
providing an IC die;
forming an antenna on the IC die, wherein the antenna is configured to communicate with another antenna coupled to another device;
forming a first wirelessly enabled functional block on the IC die; and
coupling the IC die to a substrate, wherein the first wirelessly enabled functional block is configured to wirelessly communicate with a second wirelessly enabled functional block coupled to the substrate.

15. An integrated circuit (IC) device, comprising:
an IC die; and
an antenna coupled to the IC die, wherein the antenna is configured to communicate with another antenna coupled to another device.
